# FASCICULE DE BREVET EUROPEEN

(11) **EP 3 364 340 B1**
(45) Date de publication et mention de la délivrance du brevet: **05.01.2022**
(21) Numéro de dépôt: 18157452.6
(22) Date de dépôt: 19.02.2018
(51) Int. Cl.: G06K 9/00

(54) **CAPTEUR D'EMPREINTE A LED AU NITRURE DE GALLIUM**
FINGERABDRUCKSENSOR MIT GALLIUMNITRID-LEDS
FINGERPRINT SENSOR WITH NITRIDE-GALLIUM LEDS

(30) Priorité: 21.02.2017 FR 1751359
(43) Date de publication de la demande: 22.08.2018
(73) Titulaire: Commissariat à l'énergie atomique et aux énergies alternatives, 75015 Paris (FR)
(72) Inventeur: MAINGUET, Jean-François, 38100 Grenoble (FR); TEMPLIER, François, 38000 Grenoble (FR)
(74) Mandataire: Brevalex

(56) Documents cités:
- JP-A- 2003 037 708
- US-A1- 2012 256 089

## Description

### DOMAINE TECHNIQUE

L'invention concerne le domaine des capteurs pour imager une empreinte liée aux plis particuliers de la peau, en particulier une empreinte digitale, mais également une empreinte palmaire, plantaire, ou phalangeaire. Ces diverses empreintes sont désignées ensemble sous le terme d'empreintes papillaires.

### ÉTAT DE LA TECHNIQUE ANTÉRIEURE

On connaît dans l'art antérieur différents capteurs d'empreinte papillaire, en particulier des capteurs de type optique, dans lesquels l'acquisition d'une image de l'empreinte met simplement en œuvre un éclairage de l'empreinte et une acquisition d'image en champ proche.

Ces capteurs optiques se présentent généralement sous la forme d'un empilement comprenant une couche émettrice de lumière, une matrice de photo-détecteurs, et le cas échéant une couche transparente de protection sur laquelle l'utilisateur doit positionner son doigt.

La demande de brevet FR-1563178 déposée le 23 décembre 2015 décrit un exemple d'un tel capteur, comprenant une matrice de photo-détecteurs surmontée par une série de bandes d'OLED parallèles entre elles. Dans la demande de brevet US 2012/0256089, il est décrit un autre exemple de capteur d'empreinte papillaire, avec une matrice de photo-détecteurs surmontée par des dépôts en matériau électroluminescent organique.

On connaît également le document JP 2003 037708 A, qui décrit un premier capteur d'empreinte papillaire avec des LED disposées en bordure d'une plaque de diffusion, laquelle s'étend sous une matrice de photo-détecteurs. Ce document décrit également un second capteur d'empreinte papillaire, avec des bandes électroluminescentes s'étendant sous la matrice de photo-détecteurs.

On connait également le document TWI556177B qui divulgue un capteur d'empreinte digitale dans lequel des LEDs au nitrure de gallium sont positionnées autour du capteur d'image.

Un objectif de la présente invention est de proposer une alternative à de tels capteurs.

### EXPOSÉ DE L'INVENTION

Cet objectif est atteint avec un capteur d'empreinte papillaire selon la revendication 1.

Pour réaliser des LED au nitrure de gallium et leurs circuits électroniques de contrôle, le procédé courant consiste à réaliser un ensemble de LED de façon monolithique sur un substrat de report, puis à rapporter le tout sur un deuxième substrat recevant les circuits de contrôle, de façon que chaque LED ait une électrode connectée à une piste métallique des circuits de contrôle.

Ce procédé de réalisation nécessite un alignement précis des circuits de contrôle avec les LED, lors de l'étape d'assemblage de ces deux éléments.

Dans un capteur d'empreinte papillaire, ces difficultés d'alignement sont encore décuplées, puisque le positionnement des LED est également fonction de la position des photo-détecteurs du photo-détecteur matriciel.

Par conséquent, l'homme du métier avait jusqu'à présent exclu de recourir à des LED au nitrure de gallium dans un capteur d'empreinte papillaire comprenant un dispositif d'émission lumineuse et un photo-détecteur matriciel entrelacés.

Or, les inventeurs ont eu l'idée originale de s'intéresser néanmoins aux récents développements dans le domaine des LED au nitrure de gallium.

Dans la demande de brevet PCT/FR2016/051140, il est décrit un nouveau procédé de fabrication d'un dispositif d'affichage comportant une pluralité de diodes au nitrure de gallium.

Ce procédé comprend les étapes suivantes :
- rapporter, sur une face de circuits intégrés de contrôle comportant une pluralité de pistes métalliques de connexion, un empilement actif de diode comportant au moins des première et deuxième couches semi-conductrices dopées de types de conductivité opposés, de façon que la deuxième couche de l'empilement soit électriquement connectée aux pistes métalliques des circuits de contrôle ; et
- former dans l'empilement actif des tranchées délimitant une pluralité de diodes connectées à des pistes métalliques distinctes des circuits de contrôle.

Lors de l'étape de report de l'empilement actif, sur un substrat recevant des circuits de contrôle, les positions des LED dans l'empilement actif ne sont pas encore définies. Il n'y a donc pas de contrainte forte en termes de précision d'alignement, lors du report. La délimitation des LED dans l'empilement actif peut ensuite être réalisée par des procédés de structuration offrant une précision d'alignement nettement supérieure à celle pouvant être obtenue par report d'un substrat sur un autre.

Il devient alors envisageable de réaliser un capteur d'empreinte papillaire comprenant une ou plusieurs LED au nitrure de gallium, notamment une ou plusieurs LED au nitrure de gallium entrelacée(s) avec les photo-détecteurs d'un photo-détecteur matriciel, et pilotée(s) par des circuits de contrôle réalisés de préférence en technologie CMOS.

Le recours à une technologie CMOS permet de limiter l'encombrement des circuits de contrôle, dans le capteur d'empreinte.

Grâce à la grande précision d'alignement des LED sur le substrat, le capteur d'empreinte peut comprendre des LED au nitrure de gallium réparties selon un très petit pas de pixel, par exemple 50,8 µm ou moins.

Un faible pas de répartition des LED est avantageux pour la mise en œuvre de procédés de détection du vivant, pour reconnaître si une empreinte est constituée ou non de tissu humain vivant.

Un faible pas de répartition des LED est également avantageux pour ajouter au capteur d'empreinte papillaire une fonction d'afficheur émissif.

La grande précision d'alignement des LED permet également de positionner une LED au nitrure de gallium dans un espace restreint entre deux photo-détecteurs.

En particulier, on peut positionner une LED au nitrure de gallium entre les photo-détecteurs du photo-détecteur matriciel, malgré que lesdits photo-détecteurs soient répartis selon un très petit pas de pixel (par exemple 50,8 µm, voire même 25,4 µm ou moins).

On peut ainsi entrelacer le dispositif d'émission lumineuse et le photo-détecteur matriciel, tout en ayant une bonne résolution en détection et sans supprimer de pixels du photo-détecteur matriciel.

On peut en particulier entrelacer le dispositif d'émission lumineuse avec un photo-détecteur matriciel présentant un très faible pas de pixel, ce faible pas de pixel permettant de réduire les dimensions du capteur d'empreinte, à performances égales.

Puisqu'il n'y a pas de recouvrement entre le dispositif d'émission lumineuse et le photo-détecteur matriciel, plus la surface du substrat dédiée aux LED au nitrure de gallium est importante, plus celle dédiée aux photo-détecteurs est restreinte.

Une LED au nitrure de gallium peut offrir des puissances d'émission lumineuse très élevées, malgré une faible surface, grâce à un rendement élevé (bien supérieur à celui des OLED).

On peut donc réserver beaucoup de surface du substrat aux photo-détecteurs, tout en maintenant une puissance d'émission lumineuse suffisante. On réalise ainsi un capteur d'empreinte papillaire d'une grande sensibilité, la quantité de signal optique détectée étant directement liée à la surface occupée par les photo-détecteurs.

Par exemple, le dispositif d'émission lumineuse occupe sur le substrat une surface au moins dix fois inférieure à la surface occupée par le photo-détecteur matriciel, et même au moins cinquante fois inférieure.

Ces fortes puissances d'émission lumineuse permettent en outre que les LED au nitrure de gallium soient réparties selon un pas de répartition supérieur à celui des photo-détecteurs.

La grande efficacité énergétique d'une LED au nitrure de gallium permet également de minimiser une consommation électrique du capteur d'empreinte papillaire.

Le capteur d'empreinte papillaire selon l'invention comprend avantageusement une couche de protection recouvrant le dispositif d'émission lumineuse et le photo-détecteur matriciel, et formant alors la couche la plus externe du capteur d'empreinte papillaire, du côté opposé au substrat.

En variante, la couche la plus externe du capteur d'empreinte papillaire, du côté opposé au substrat, est par exemple une couche conductrice servant également de protection à l'égard des décharges électrostatiques.

Le photo-détecteur matriciel s'étend selon une surface dite surface de capture du capteur d'empreinte papillaire, entrelacé avec le dispositif d'émission lumineuse. La surface de capture est par exemple une surface comprise entre 3x3 mm² et 12x12 mm², par exemple 4x4 mm², ou 7x7 mm², ou 10x12 mm².

En fonctionnement, les LED au nitrure de gallium émettent un rayonnement lumineux en direction de l'empreinte, et un rayonnement est rétrodiffusé par l'empreinte et reçu par le photo-détecteur, sensible sur au moins une partie du spectre d'émission des LED au nitrure de gallium.

D'autres caractéristiques avantageuses, optionnelles, d'un capteur d'empreinte papillaire selon l'invention, sont mentionnées ci-après, et/ou dans les revendications 2 à 13.

En particulier, l'invention concerne notamment un capteur d'empreinte papillaire, comprenant un dispositif d'émission lumineuse et un photo-détecteur matriciel, entrelacés ensemble dans et/ou au-dessus d'un même substrat semiconducteur, dans lequel :
- le dispositif d'émission lumineuse est constitué de plusieurs diodes électroluminescentes au nitrure de gallium, dites LED au nitrure de gallium, ou d'une unique LED au nitrure de gallium présentant une série d'ouvertures traversantes ; et
- le substrat reçoit des circuits de contrôle comportant une pluralité de pistes métalliques de connexion, chaque LED au nitrure de gallium s'étendant au-dessus d'une piste métallique des circuits de contrôle.

Le dispositif d'émission lumineuse et le photo-détecteur matriciel sont entrelacés, c'est-à-dire imbriqués ensemble sans recouvrement entre une LED au nitrure de gallium du dispositif d'émission lumineuse et un photo-détecteur du photo-détecteur matriciel.

Dit encore autrement, le dispositif d'émission lumineuse et le photo-détecteur matriciel sont entrecroisés ensemble, sans recouvrement entre une LED au nitrure de gallium du dispositif d'émission lumineuse et un photo-détecteur du photo-détecteur matriciel.

Le dispositif d'émission lumineuse est alors constitué de plusieurs LED au nitrure de gallium s'étendant chacune entre des photodiodes du photo-détecteur matriciel, ou d'une unique LED au nitrure de gallium présentant une série d'ouvertures traversantes dans lesquelles s'étendent des photodiodes du photo-détecteur matriciel.

Avantageusement, le photo-détecteur matriciel s'étend dans un premier étage du capteur d'empreinte papillaire, et le dispositif d'émission lumineuse s'étend dans un deuxième étage du capteur d'empreinte papillaire, au-dessus dudit premier étage.

Dit autrement, le capteur d'empreinte papillaire comprend successivement un premier étage dans lequel s'étend le photo-détecteur matriciel, et un deuxième étage dans lequel s'étend le dispositif d'émission lumineuse, le deuxième étage s'étendant au-dessus du premier étage, superposé à ce dernier selon un axe vertical (Oz).

L'axe vertical (Oz) est défini comme étant un axe orthogonal au plan du substrat.

Dit encore autrement, le photo-détecteur matriciel s'étend selon une surface dite surface de capture du capteur d'empreinte papillaire, et l'axe vertical (Oz) est défini comme étant un axe orthogonal à ladite surface de capture.

Cet axe vertical est orienté depuis le substrat, vers une surface de contact du capteur d'empreinte papillaire. Ainsi, le deuxième étage est plus proche de la surface de contact que le premier étage, selon cet axe vertical. La surface de contact du capteur d'empreinte papillaire est une surface externe du capteur, destinée à s'étendre en contact physique direct avec l'empreinte papillaire à imager, en fonctionnement.

Avantageusement, la ou les LED(s) au nitrure de gallium du dispositif d'émission lumineuse est (sont) décalée(s) longitudinalement et transversalement relativement à des photo-détecteurs du photo-détecteur matriciel. Les axes longitudinal et transverse correspondent aux axes (Ox) et (Oy) du plan (Oxy) parallèle à la surface de capture du photo-détecteur matriciel.

En particulier, la ou les LED(s) au nitrure de gallium constituant le dispositif d'émission lumineuse est (sont) décalée(s) longitudinalement et transversalement par rapport à des photodiodes formant des photo-détecteurs du photo-détecteur matriciel, de manière à ce qu'au moins une partie du dispositif d'émission lumineuse ne recouvre pas les photodiodes.

De préférence, il n'y a pas de recouvrement entre une LED au nitrure de gallium du dispositif d'émission lumineuse et un photo-détecteur du photo-détecteur matriciel.

De préférence, le dispositif d'émission lumineuse est constitué de plusieurs LED au nitrure de gallium, réparties selon une matrice de répartition à N lignes et M colonnes, avec N et M des entiers supérieurs à 3 pouvant être égaux.

En variante, le dispositif d'émission lumineuse est constitué de plusieurs LED au nitrure de gallium, chacune en forme de bande, réparties selon une ou deux colonnes de bandes parallèles entre elles.

Le capteur d'empreinte papillaire selon l'invention peut comprendre des parois, qui s'étendent chacune entre au moins une LED au nitrure de gallium appartenant au dispositif d'émission lumineuse, et une photodiode appartenant au photo-détecteur matriciel, chaque paroi étant réfléchissante à une longueur d'onde centrale d'émission de ladite LED au nitrure de gallium.

Selon un mode de réalisation avantageux, le dispositif d'émission lumineuse est polychromatique, certaines au moins des LED au nitrure de gallium comprenant un empilement actif de LED recouvert par un ou plusieurs empilement(s) de conversion photoluminescent(s).

Une couche conductrice formant électrode supérieure de LED et électrode supérieure de matériau pyroélectrique est de préférence de l'oxyde d'indium-étain.

L'invention concerne aussi un procédé de fabrication d'un capteur d'empreinte papillaire selon l'invention selon la revendication 15.

Elle concerne en particulier un procédé de fabrication d'un capteur d'empreinte papillaire selon l'une quelconque des revendications 1 à 13, comportant les étapes suivantes :
a) rapporter, sur une face du substrat semiconducteur recevant les circuits de contrôle, un empilement actif de LED comportant au moins des première et deuxième couches semi-conductrices dopées de types de conductivité opposés, de façon que la deuxième couche de l'empilement soit électriquement connectée aux pistes métalliques des circuits de contrôle ;
b) former dans l'empilement actif des tranchées pour délimiter les plusieurs LED au nitrure de gallium ou pour percer les ouvertures traversantes dans l'unique LED au nitrure de gallium ; et
c) réaliser le photo-détecteur matriciel dans ou au-dessus du substrat, l'étape c) étant mise en œuvre avant ou après les étapes a) et b).

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :
- la figure 1 illustre de façon schématique, et selon une vue en coupe, un premier mode de réalisation d'un capteur d'empreinte selon l'invention ;
- les figures 2A à 2D illustrent de façon schématique, et selon des vues de dessus, différentes variantes de répartition des LED et des photo-détecteurs dans un capteur d'empreinte selon l'invention ;
- les figures 3A et 3B illustrent de façon schématique, et selon des vues de dessus, différents mode de réalisation de dispositifs d'éclairage polychromatique, dans un capteur d'empreinte selon l'invention ;
- la figure 4 illustre un deuxième mode de réalisation d'un capteur d'empreinte selon l'invention, dans lequel le dispositif d'émission lumineuse est entrelacé avec des éléments de conversion pyroélectrique ;
- la figure 5 illustre une première variante du mode de réalisation de la figure 4, comportant en outre une couche conductrice assurant une protection à l'égard des décharges électrostatiques ;
- la figure 6 illustre une deuxième variante du mode de réalisation de la figure 4, dans lequel des électrodes du capteur d'empreinte selon l'invention forment une couche conductrice assurant une protection à l'égard des décharges électrostatiques ;
- les figures 7 et 8 illustrent de manière schématique le principe d'une détection thermique de type actif, avec chauffage des éléments de conversion pyroélectrique ;
- la figure 9 illustre un troisième mode de réalisation d'un capteur d'empreinte selon l'invention, comprenant des moyens de chauffage des éléments de conversion pyroélectrique ;
- les figures 10 et 11 illustrent deux variantes d'un quatrième mode de réalisation d'un capteur d'empreinte selon l'invention, dans lequel le photo-détecteur matriciel est constitué d'une matrice de diodes PiN ; et
- la figure 12 illustre de manière schématique une application avantageuse du capteur d'empreinte selon l'invention.

### EXPOSÉ DÉTAILLÉ DE MODES DE RÉALISATION PARTICULIERS

Par souci de clarté, seuls les éléments utiles à la compréhension des modes de réalisation décrits ont été représentés et sont détaillés. En particulier, les circuits de contrôle ne sont pas détaillés, l'invention ne résidant pas dans ces circuits de contrôle. Pour les mêmes raisons, la composition des empilements formant la ou les diode(s) au nitrure de gallium n'est pas détaillée.

Dans la description qui suit, les termes « sur », « au-dessus », « sous », « dessous », se rapportent à l'orientation des figures correspondantes. Pour plus de clarté, on a représenté sur certaines des figures les axes (Ox), (Oy) et/ou (Oz) d'un repère orthonormé. L'axe (Oz) correspond à la verticale.

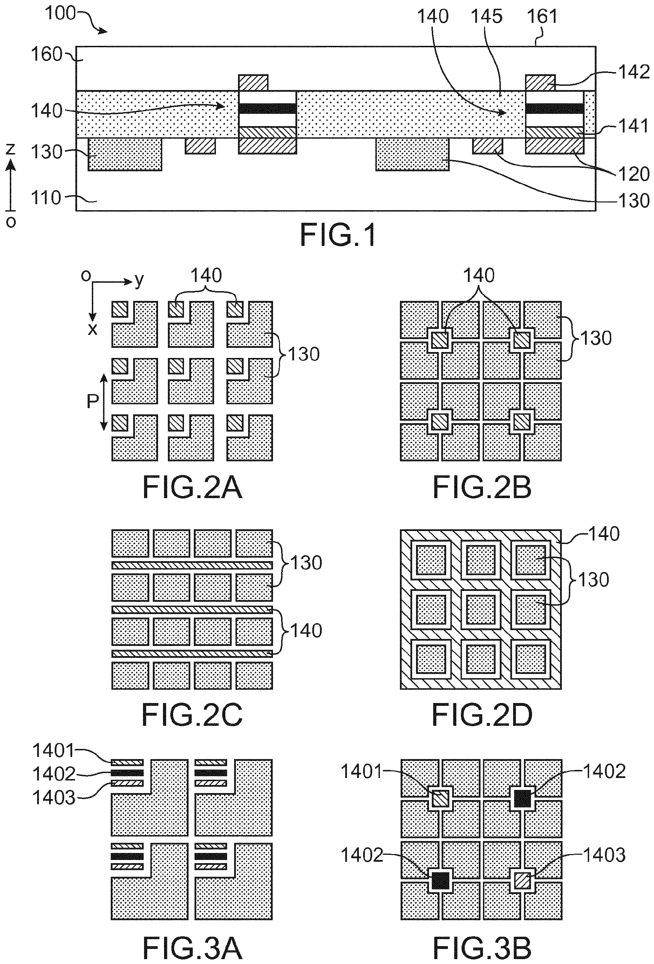

La figure 1 illustre de façon schématique, et selon une vue en coupe, un premier mode de réalisation d'un capteur d'empreinte papillaire 100 selon l'invention. Le capteur d'empreinte 100 comprend un substrat semiconducteur 110, par exemple en silicium, comportant des circuits de contrôle (non représentés) réalisés de préférence en technologie CMOS. Les circuits de contrôle comportent des pistes métalliques de connexion 120, assurant la connexion électrique entre ces circuits de contrôle et des dispositifs électroniques montés sur le substrat. Les pistes métalliques de connexion 120 sont formées chacune par une fine couche métallique enterrée dans le substrat 110, et affleurant à sa surface supérieure.

Une pluralité de photodiodes 130 s'étend directement dans le substrat 110. Les photodiodes 130 sont formées par de simples jonctions PN, et s'étendent directement dans le silicium du substrat 110. Chaque photodiode 130 est formée par implantation de dopants dans le silicium, et connectée à des circuits de contrôle par des moyens connus de l'homme du métier, de façon à permettre que des rayons lumineux incidents sur une face supérieure du substrat parviennent jusqu'à la jonction PN correspondante.

Les photodiodes 130 sont agencées selon une matrice de répartition rectangulaire, de préférence carrée, et forment ensemble un photo-détecteur matriciel. Les photodiodes 130 s'étendent ensemble selon une surface dite surface de capture du capteur d'empreinte papillaire. La surface de capture s'étend selon un plan (Oxy), comme le montre la figure 1. La résolution du photo-détecteur matriciel est de préférence de 500 dpi, soit un pas de pixel de 50,8 µm. En variante, cette résolution est de 1000 dpi (soit un pas de pixel de 25,4 µm) ou même 2000 dpi (soit un pas de pixel de 12,7 µm).

Des LED au nitrure de gallium 140 s'étendent au-dessus du substrat, en recouvrant chacune une unique piste métallique 120 du substrat. Dans la suite, les LED au nitrure de gallium sont notées simplement « LED GaN ». De préférence, une projection verticale (selon (Oz)) d'une LED GaN 140 coïncide avec l'étendue de la piste métallique 120 correspondante. Ladite piste métallique 120 assure la connexion entre une électrode inférieure de la LED GaN correspondante, et des circuits de contrôle dans le substrat 110. On comprend ainsi que les circuits de contrôle sont destinés à piloter les LED GaN 140.

Chaque LED GaN 140 comporte ici un empilement actif de LED comprenant au moins des première et deuxième couches semi-conductrices dopées de types de conductivité opposés. De préférence, ces deux couches semi-conductrices sont séparées par une couche émissive par exemple à base de puits quantiques, ou présentant un dopage dit intrinsèque.

De manière avantageuse, chaque LED GaN 140 et la piste métallique 120 correspondantes sont séparées par un plot métallique 141. Le plot métallique 141 est en contact physique direct, d'un côté avec la piste métallique 120, et de l'autre avec la LED GaN 140. Le plot métallique 141 présente la même section que l'empilement actif de la LED GaN, dans un plan (xOy) parallèle au plan du substrat. Les plots métalliques 141 proviennent d'une étape avantageusement mise en œuvre lors de la fabrication de LED(s) au nitrure de gallium selon le procédé décrit dans l'exposé de l'invention. Cette étape consiste à recouvrir d'une couche métallique l'empilement actif de LED et/ou le substrat recevant des circuits de contrôle, avant le report de l'empilement actif de LED. Cette couche métallique peut améliorer et/ou faciliter la fixation de l'empilement actif de LED sur le substrat recevant les circuits de contrôle. Lors de la gravure de tranchées délimitant une pluralité de diodes (ou structurant une unique diode), la couche métallique est structurée avec l'empilement actif de LED ce qui forme les plots métalliques 141. Le cas échéant, des pistes métalliques de connexion 120 du substrat CMOS peuvent être gravées lors de la même étape de gravure, de sorte que ces pistes ne dépassent pas à côté d'une LED GaN.

Les LED GaN 140 forment ensemble des moyens d'émission lumineuse, aussi appelés dispositif d'émission lumineuse. Elles sont réparties ici sur le substrat 110 recevant les photodiodes 130, sans recouvrir ces dernières. Autrement dit, les LED GaN 140 et les photodiodes 130 ne sont pas superposées l'une sur l'autre selon l'axe (Oz). Ainsi, les LED GaN 140 sont décalées longitudinalement et transversalement par rapport aux photodiodes 130 (c'est-à-dire selon les axes (Ox) et (Oy)).

On détaille dans la suite différents exemples de répartition des photodiodes 130 et des LED GaN 140, réalisant un entrelacement du photo-détecteur matriciel avec le dispositif d'émission lumineuse 140.

Les espaces entre les LED GaN 140 sont remplis par un isolant électrique 145 transparent. En d'autres termes, des LED GaN 140 distantes les unes des autres sont séparées par de l'isolant électrique 145 transparent. Dans tout le texte, le terme transparent implique un coefficient de transmission supérieur à 80%, et même supérieur à 90%, à la longueur d'onde d'émission des LED GaN 140 (le cas échéant aux longueurs d'onde d'émission respectives des différents types de LED GaN). L'isolant électrique 145 est par exemple de l'oxyde de silicium. Les LED GaN 140 et l'isolant électrique 145 forment ensemble un étage supplémentaire du capteur d'empreinte papillaire 100. Par étage supplémentaire, on entend un étage de plus par rapport au substrat semi-conducteur 110 intégrant les photodiodes 130. Ici, l'isolant électrique 145 remplit entièrement les espaces entre les LED GaN 140, formant avec elles une couche sans ouverture.

Comme cela est illustré par la figure 1, le capteur d'empreinte papillaire 100 comprend successivement, selon la direction de l'axe Oz, un premier étage comprenant le substrat semi-conducteur 110 dans lequel des photodiodes 130 sont situées, ainsi qu'un deuxième étage comprenant l'isolant électrique 45 transparent, dans lequel les LED GaN 140 sont situées. On comprend alors que le premier étage est situé en dessous du deuxième étage et donc que les photodiodes 130 sont situées en dessous des LED GaN.

Les LED GaN 140 sont recouvertes chacune d'une électrode supérieure 142, en matériau conducteur tel que du métal ou de l'oxyde d'indium-étain. Les électrodes supérieures 142 sont connectées à une piste métallique du substrat par un via (non représenté) qui traverse ledit étage supplémentaire du capteur d'empreinte 100.

L'ensemble est recouvert d'une fine couche de protection 160, transparente, assurant une protection à l'égard de contacts répétés avec des tissus humains. La couche de protection 160 peut être un conducteur électrique ou un isolant, selon qu'elle recouvre des électrodes portées au même potentiel ou à des potentiels différents. La couche de protection 160 peut être constituée d'une couche d'oxyde, d'une couche d'un polymère époxyde (peinture époxy), ou d'une couche de carbone amorphe dite DLC (pour « Diamond-Like Carbon »), etc. Elle présente avantageusement une épaisseur inférieure à 30 µm, et même inférieure à 20 µm, voire inférieure à 1 µm pour du DLC. Elle forme la couche la plus externe du capteur d'empreinte 100, du côté opposé au substrat semiconducteur 110. On comprend alors que le capteur d'empreinte papillaire 100 comprend un troisième étage, comprenant la couche de protection 160, situé au-dessus, selon la direction de l'axe Oz, du deuxième étage comprenant l'isolant électrique 145 transparent dans lequel les LED GaN 140 sont situées.

En fonctionnement, une empreinte est appuyée contre une surface de contact 161 du capteur d'empreinte, sur une face externe de la couche de protection, du côté opposé au substrat 110. Les LED GaN 140 émettent un rayonnement lumineux en direction de la couche de protection 160, qui est rétrodiffusé par l'empreinte. Le rayonnement rétrodiffusé est reçu par les photodiodes 130, sensibles sur au moins une partie du spectre d'émission des LED GaN 140.

Une distance entre la surface de contact 161 et les photodiodes 130 est de préférence inférieure au pas de répartition de celles-ci, par exemple inférieure ou égale à 50,8 µm, et même inférieure ou égale à 25 µm. Cette distance est par exemple mesurée selon l'axe Oz. Le capteur d'empreinte selon l'invention peut ainsi former un dispositif compact, fonctionnant en champ proche, sans moyens de focalisation disposés entre la surface de contact et les photodiodes 130. Les photodiodes sont avantageusement réparties selon une matrice carrée. Si elles sont réparties selon une matrice rectangulaire, on considère le plus petit parmi les deux pas définissant alors la répartition des photodiodes. Avantageusement, une distance entre la surface de contact 161 et les photodiodes 130 est mesurée à partir d'un plan recevant les électrodes supérieures des photodiodes (ici, la face supérieure du substrat semiconducteur, du côté de la surface de contact).

Les figures 2A à 2D illustrent différentes variantes de répartition des LED GaN 140 et des photodiodes 130, représentées en vue de dessus. Dans chacune de ces variantes, les photodiodes 130 sont agencées selon une matrice carré de pas P, où P vaut par exemple 50,8 µm, ou 25,4 µm, voire même moins. La matrice de photodiodes est par exemple un carré d'au moins 100 pixels de côté.

Sur la figure 2A, le dispositif d'émission lumineuse est constitué d'une pluralité de LED GaN 140, réparties selon une matrice de répartition carré de même pas P. Une répartition matricielle permet que les LED GaN 140 forment également un dispositif d'affichage émissif (ici, un dispositif d'affichage monochrome). Afin de maximiser une surface de capture du capteur d'empreinte papillaire, chaque photodiode 130 présente, selon une vue de dessus, un renfoncement à l'intérieur duquel s'étend une LED GaN 140. Chaque LED GaN 140 présente en particulier une forme carrée, disposée au creux d'une photodiode 130 en forme de L.

Une LED GaN peut émettre de fortes puissances optiques, même en présentant de très petites dimensions. Ainsi, chaque LED GaN peut présenter selon une vue de dessus une forme carrée ou rectangulaire de moins de 10 µm de côté, par exemple 4 µm ou 3 µm ou 2 µm de côté. Les faibles dimensions de chaque LED GaN permettent qu'elles soient réparties selon un faible pas de pixel, sans pour autant empêcher une bonne détection de signal par les photodiodes.

La variante illustrée en figure 2B diffère de celle de la figure 2A en ce que le pas de répartition des LED GaN 140 est un multiple entier du pas de répartition des photodiodes 130. Les LED GaN 140 peuvent toujours former un dispositif d'affichage émissif, permettant par exemple l'affichage de motifs simples tels qu'une croix lorsque le capteur d'empreinte est prêt à recevoir une empreinte, ou lorsqu'une empreinte a été correctement détectée. Chaque LED GaN 140 est disposée ici à l'angle de quatre photodiodes 130. Chaque photodiode 130 présente un renfoncement à l'intérieur duquel s'étend un coin d'une LED GaN 140. Cette variante permet de combiner un très petit pas de pixel du photo-détecteur matriciel, réalisant un capteur d'empreinte de haute résolution, et un pas de pixel plus élevé pour les LED GaN, offrant un éclairage suffisant pour la détection d'empreinte et pouvant former un dispositif d'affichage émissif de bonne qualité. Par exemple, la résolution du photo-détecteur matriciel est de 2000 dpi, alors que la résolution de la matrice de LED GaN est de 300 dpi. Selon des variantes non représentées, la répartition des LED GaN ne présente pas partout le même pas.

En variante, les photodiodes et les LED GaN sont réparties selon une matrice rectangulaire. Les LED GaN peuvent alors être réparties selon le même pas de répartition que les photodiodes, selon chaque dimension du plan du photo-détecteur matriciel. Alternativement, selon chaque dimension du plan du photo-détecteur matriciel, le pas de répartition des LED GaN est un multiple du pas de répartition des photodiodes.

Sur la figure 2C, chaque LED GaN a une forme de bande, et s'étend entre deux lignes de photodiodes 130, d'un bord à l'autre de la surface de capture définie par l'ensemble des photodiodes 130. Les LED GaN peuvent alors être connectées aux circuits de contrôle, uniquement depuis le bord du capteur d'empreinte. Cette variante permet de réaliser des figures d'éclairement constituées de bandes lumineuses et de bandes sombres. La demande de brevet FR-1563180, déposée le 23 décembre 2015, décrit un procédé de reconnaissance du vivant, utilisant de telles figures d'éclairement pour déterminer un coefficient d'absorption et un coefficient de diffusion réduit caractéristiques d'une l'empreinte, et ainsi reconnaître si l'empreinte est constituée ou non de tissu humain vivant. Cette variante est donc particulièrement avantageuse pour reconnaître si une empreinte est constituée ou non de tissu humain vivant, à partir de sa réponse à des éclairements prédéterminés. Le terme « bande » désigne ici n'importe quel motif de forme allongée, tel qu'un long rectangle, un serpentin, une ligne de triangles, etc. Une bande en forme de long rectangle présente par exemple une largeur inférieure ou égale à 4 µm, et une longueur de plusieurs centaines de µm, voire plusieurs millimètres, avantageusement la longueur de la surface de capture.

Selon une variante non représentée, le dispositif d'émission lumineuse est constitué de deux colonnes de bandes de LED. Chaque colonne peut être connectée à des circuits de contrôle depuis un bord respectif du capteur d'empreinte.

Sur la figure 2D, le dispositif d'émission lumineuse est constitué d'une unique LED GaN 140, en forme de grille. Chaque ouverture de la grille reçoit une photodiode 130. Cette variante offre une connectique particulièrement simple pour le dispositif d'émission lumineuse (mais bien sûr ne peut pas former un afficheur émissif). Chaque ouverture de la grille peut également recevoir plusieurs photodiodes.

Dans chacune des variantes détaillées ci-dessus, des LED GaN s'étendent chacune entre des photodiodes, ou des photodiodes s'étendent chacune dans les trous d'une LED en forme de grille. La ou les LED GaN forme(nt) ainsi un dispositif d'émission lumineuse entrelacé avec un photo-détecteur matriciel. Par « entrelacé », il est donc entendu que des LED GaN 140 s'étendent chacune, sans recouvrement, entre les photodiodes 130 du photo-détecteur matriciel, ou que dans le cas d'une unique LED GaN 140 se présentant sous la forme d'une grille ayant des ouvertures, les ouvertures sont destinées à recevoir les photodiodes 130 du photo-détecteur matriciel.

Dans un cas extrême, le capteur d'empreinte selon l'invention est un capteur à balayage, comportant seulement quelques lignes de photodiodes et une ligne de LED GaN.

Le dispositif d'émission lumineuse peut être polychromatique, c'est-à-dire adapté à émettre à différentes longueurs d'onde, par exemple trois longueurs d'onde telles que le rouge, le bleu, ou le vert. Le dispositif d'émission lumineuse peut être constitué par différents types d'empilements actifs de LED, qui diffèrent par leurs longueurs d'onde d'émission respectives. Selon une variante avantageuse, le dispositif d'émission lumineuse est constitué d'une pluralité d'empilements actifs de LED ayant tous le même spectre d'émission, et dont certains au moins sont recouverts par un ou plusieurs empilement(s) de conversion photoluminescent(s).

On nomme alors « LED GaN » l'ensemble constitué par un empilement actif de LED et le cas échéant le ou les empilement(s) de conversion photoluminescent(s) correspondant. Le dispositif d'émission lumineuse peut alors être réalisé à l'aide du procédé décrit dans la demande de brevet français n°16 54282. Ce procédé comprend des étapes de dépôt et gravure de différents types d'empilements de conversion photoluminescents, au-dessus d'une série d'empilements actifs de LED à base de nitrure de gallium.

Les figures 3A et 3B illustrent deux exemples de réalisation de dispositifs d'émission lumineuse polychromatique.

Sur la figure 3A, les LED GaN sont réparties en blocs de trois LED, selon une matrice de répartition carrée. Chaque bloc consiste en trois LED GaN (1401, 1402, 1403) directement voisines, émettant respectivement dans le rouge, le bleu, et vert.

Sur la figure 3B, les LED GaN sont réparties selon une matrice de répartition carrée, les LED étant alternativement une LED GaN (1401) émettant dans le rouge, ou une LED GaN émettant dans le bleu (1402), ou une LED GaN émettant dans le vert (1403).

De nombreuses autres variantes peuvent être mises en œuvre. Par exemple, les LED GaN peuvent être en forme de bande, les bandes étant alternativement rouge, bleu ou verte. On peut également utiliser d'autres couleurs que le rouge, le bleu et le vert. Un dispositif d'émission lumineuse polychromatique est avantageux pour la mise en œuvre de procédés de reconnaissance du vivant. Ils peut également former un dispositif d'affichage émissif en couleurs.

De manière avantageuse, le capteur d'empreinte comprend des moyens (non représentés) pour éviter que le rayonnement émis par une LED GaN ne soit reçu directement par une photodiode voisine, sans avoir été d'abord rétrodiffusé sur une empreinte. Par exemple, des parois peuvent s'étendre entre une LED GaN et des photodiodes voisines, réfléchissantes à la longueur d'onde centrale d'émission de ladite LED GaN. Une paroi est dite réfléchissante lorsqu'elle présente un coefficient de réflexion supérieur à 70%, et même 80%, à ladite longueur d'onde centrale d'émission. Lesdites parois sont formées par exemple par des plots métalliques de forme annulaire entourant chacun une LED GaN, ou par des barrières métalliques s'étendant chacune en ligne droite de part et d'autre d'une LED GaN en forme de bande.

En complément ou en variante, les LED GaN sont agencées pour émettre un faisceau lumineux collimaté. Pour cela, l'empilement actif de LED peut comprendre des miroirs de Bragg formant une cavité résonante (RCLED, pour « Resonant Cavity LED »). Afin d'éviter d'aveugler les photodiodes, on peut également allumer les LED GaN de façon séquentielle, et ne lire que les photodiodes situées à distance d'une LED GaN allumée.

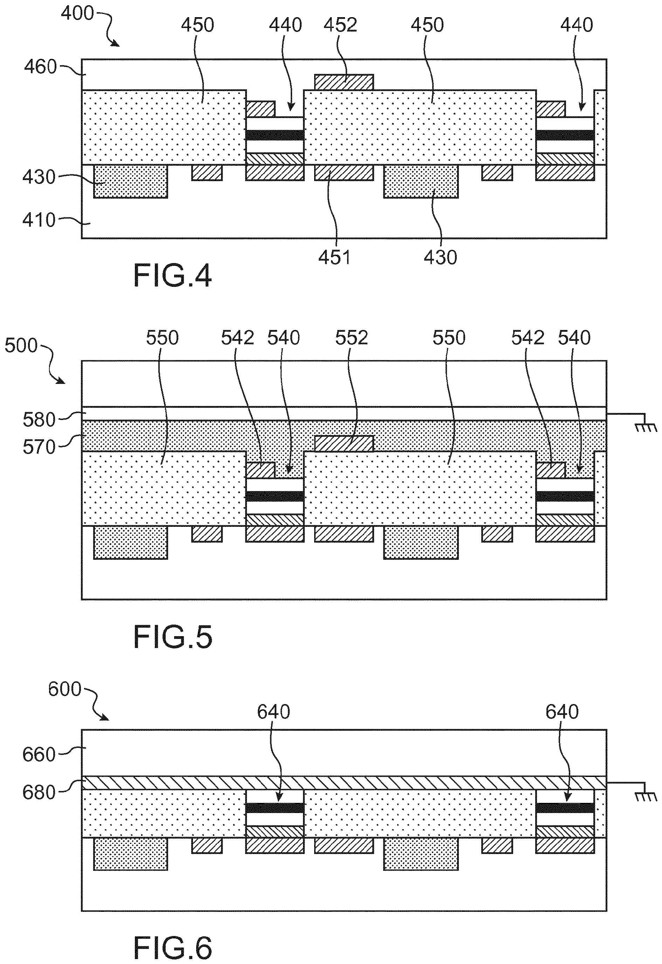

La figure 4 illustre un mode de réalisation particulièrement avantageux dans lequel le dispositif d'émission lumineuse est entrelacé avec des éléments de conversion pyroélectrique. Le capteur d'empreinte 400 de la figure 4 ne sera décrit que pour ses différences relativement au mode de réalisation de la figure 1.

Le capteur d'empreinte 400 de la figure 4 comprend ici une couche structurée 450 en matériau pyroélectrique, s'étendant avec les LED GaN 440 dans l'étage supplémentaire du capteur d'empreinte tel que décrit ci-avant, au-dessus du substrat 410. La pyroélectricité d'un matériau est sa capacité à générer des charges électriques, dites pyroélectriques, en réponse à une variation de température. Le matériau pyroélectrique est par exemple un copolymère de polyfluorure de vinylidène (PVDF-TrFE), ou un nitrure III-V tel que le nitrure d'aluminium, ou un mélange de nitrures comprenant du nitrure d'aluminium.

Par nature, les matériaux pyroélectriques sont de bons isolants électriques, de sorte que la couche structurée 450 en matériau pyroélectrique remplace avantageusement l'isolant électrique 145 utilisé dans le premier mode de réalisation. La couche structurée 450 en matériau pyroélectrique doit en outre être transparente, pour laisser passer la lumière jusqu'aux photodiodes 430. Pour cela, la couche structurée 450 en matériau pyroélectrique peut présenter une faible épaisseur, par exemple moins de 1 µm, et/ou être constituée d'un matériau pyroélectrique transparent tel que le PVDF-TrFE. Dans la suite, la couche structurée 450 en matériau pyroélectrique est nommée simplement « matériau pyroélectrique ».

Le matériau pyroélectrique 450 s'étend dans les espaces entre les LED GaN 440 (ou dans les ouvertures traversantes d'une unique LED GaN). Ici, le matériau pyroélectrique 450 forme avec les LED GaN 440 une couche s'étendant sans ouverture au-dessus du substrat. De préférence, le matériau pyroélectrique 450 ne recouvre pas les LED GaN 440. En variante, le matériau pyroélectrique 450 peut former des bandes distinctes, entre les LED GaN.

On a représenté le cas où le matériau pyroélectrique 450 dépasse au-dessus des LED GaN, l'épaisseur du matériau pyroélectrique étant comprise par exemple entre 2 et 3 µm, alors que l'épaisseur des LED GaN est d'environ 0,5 µm.

Le matériau pyroélectrique 450 recouvre un ensemble de pistes métalliques 451 affleurant à la surface supérieure du substrat 410, et formant ensemble une matrice d'électrodes inférieures du matériau pyroélectrique. Le matériau pyroélectrique 450 est également recouvert d'un ensemble de pistes conductrices 452 situées chacune au regard d'une électrode inférieure 451 du matériau pyroélectrique, et formant ensemble une matrice d'électrodes supérieures du matériau pyroélectrique. Si les électrodes supérieures 452 ne sont pas transparentes à la longueur d'onde d'émission des LED GaN, elles s'étendent sur le matériau pyroélectrique sans recouvrir les photodiodes, comme illustré en figure 4.

Les électrodes inférieures, supérieures, et le matériau pyroélectrique, forment ensemble une matrice d'éléments de conversion pyroélectrique.

Chaque élément de conversion pyroélectrique comprend :
- une électrode supérieure 452, connectée à une source de potentiel constant, par exemple à la masse (ou même la terre) ;
- une électrode inférieure 451, connectée à des circuits de mesure de charges pyroélectriques (non représentés) ; et
- une portion du matériau pyroélectrique, directement interposée entre ces électrodes, destinée à être exposée à une variation temporelle de température et permettant de générer des charges pyroélectriques entre ces électrodes, correspondant à ladite variation de température.

Ces éléments de conversion pyroélectrique forment ensemble une matrice de transducteurs de variation temporelle de température, et plus particulièrement un capteur d'empreinte papillaire de type thermique, permettant de discriminer des éléments de conversion pyroélectrique surmontés par une crête, respectivement par une vallée d'une empreinte.

On réalise ainsi un capteur d'empreinte dans lequel le dispositif d'émission lumineuse est entrelacé avec les pixels d'un capteur thermique, de façon à fournir des mesures optiques et thermiques se rapportant à une même région d'une empreinte.

On peut ainsi consolider et/ou compléter et/ou corriger des mesures optiques par des mesures thermiques, pour fournir une image de meilleure qualité. Par exemple, des mesures optiques réalisées sur un doigt sec sont complétées par des mesures thermiques, plus fiables sur doigt sec. Les mesures thermiques sont obtenues sans augmentation sensible de l'encombrement du capteur d'empreinte, puisque les éléments de conversion pyroélectrique sont réalisés principalement en remplaçant tout ou partie d'un isolant électrique par un matériau présentant en outre des propriétés de pyroélectricité.

De préférence, un pas de répartition des éléments de conversion pyroélectriques est égal à un pas de répartition des photodiodes 430.

Les circuits de mesure de charges pyroélectriques sont avantageusement intégrés dans le substrat 410, en technologie CMOS, et mettent en œuvre des techniques de mesures passives (lecture en courant des charges) ou actives (lecture en tension), avec une série de transistors. Les circuits de mesure de charges pyroélectriques et les circuits de mesure pour la lecture des photodiodes peuvent être distincts, ou partagés en utilisant un ou plusieurs transistors pour aiguiller les charges. Un circuit de sélection permet de piloter chaque LED individuellement au niveau du pixel.

Les éléments de conversion pyroélectrique et les LED GaN sont recouverts par une deuxième couche d'isolant électrique 460, transparent. De préférence, cette deuxième couche d'isolant électrique 460 forme également une protection à l'égard des contacts répétés avec les tissus humains. Elle est par exemple en DLC.

Selon une variante non représentée, les différents éléments de conversion pyroélectrique partagent une même électrode supérieure s'étendant au-dessus de la matrice d'électrodes inférieures.

Selon une autre variante, ce sont les électrodes supérieures qui sont connectées aux circuits de mesure, la ou les électrode(s) inférieure(s) étant connectée(s) à une source de potentiel constant.

Selon une autre variante, le matériau pyroélectrique et les LED GaN s'étendent jusqu'à la même hauteur au-dessus du substrat. La plus faible épaisseur de matériau pyroélectrique est alors compensée par une forte sensibilité des circuits de mesure, intégrés en technologie CMOS dans le substrat, et comprenant par exemple un amplificateur pour chaque élément de conversion pyroélectrique.

Selon une autre variante, le matériau pyroélectrique s'étend dans des ouvertures traversantes gravées dans un isolant électrique distinct, entre les LED GaN (ou dans les ouvertures traversantes d'une unique LED GaN).

Selon une autre variante, le matériau pyroélectrique s'étend d'un seul tenant et sans ouverture au-dessus du substrat, une fine couche de matériau de conversion pyroélectrique recouvrant alors la ou les LED GaN.

Des charges peuvent s'accumuler lorsque le doigt est en contact avec le capteur d'empreinte, jusqu'à provoquer une décharge électrostatique. De préférence, le capteur d'empreinte selon l'invention comprend en outre une protection à l'égard des décharges électrostatiques.

Le capteur d'empreinte 500 de la figure 5 ne sera décrit que pour ses différences relativement au mode de réalisation de la figure 4. Dans ce capteur d'empreinte 500, les LED GaN 540, le matériau pyroélectrique 550, et leurs électrodes supérieures respectives 542, 552, sont recouverts d'un deuxième isolant électrique 570, transparent, tel que de l'oxyde de silicium.

Le deuxième isolant électrique 570 est lui-même recouvert d'une couche conductrice 580 connectée à une source de potentiel constant (de préférence la masse, et encore plus préférentiellement la terre), pour protéger le capteur d'empreinte à l'égard des décharges électrostatiques. Cette couche conductrice forme également un blindage électromagnétique, notamment à l'égard de rayonnements électromagnétiques à 50 ou 60 Hz. La couche conductrice 580 est constituée d'un matériau électriquement conducteur et transparent, de préférence de l'oxyde d'indium-étain (ITO). Elle présente une épaisseur de quelques centaines de nanomètres, de préférence moins de 1 µm. La couche conductrice 580 s'étend sans ouverture, au-dessus du substrat, en recouvrant l'ensemble des photodiodes du photo-détecteur matriciel et l'ensemble du dispositif d'émission lumineuse. Elle est elle-même recouverte d'une couche de protection 560, optionnelle, telle que décrite en référence à la figure 1.

La figure 6 illustre une variante d'un capteur d'empreinte 600 selon l'invention, dans laquelle les électrodes supérieures des LED GaN et les électrodes supérieures des éléments de conversion pyroélectrique sont formées ensemble d'un seul tenant. Une solution consiste à remplacer la pluralité d'électrodes supérieures par une unique couche métallique, percée par des ouvertures traversantes pour laisser passer la lumière au-dessus des LED GaN et des photodiodes.

La figure 6 illustre une solution plus astucieuse, dans laquelle une unique couche conductrice 680 s'étend d'un seul tenant et sans ouverture au-dessus du substrat, en contact physique direct avec les empilements de LED et le matériau pyroélectrique. La couche conductrice 680 s'étend au-dessus de l'ensemble des photodiodes du photo-détecteur matriciel et l'ensemble du dispositif d'émission lumineuse. Cette unique couche conductrice 680 est constituée d'un matériau électriquement conducteur, et transparent, de préférence de l'oxyde d'indium-étain (ITO).

Cette unique couche conductrice 680 est connectée à une source de potentiel constant, de préférence la masse, et encore plus préférentiellement la terre. Elle forme les électrodes supérieures des LED GaN 640, et les électrodes supérieures des éléments de conversion pyroélectrique. Comme elle ne présente pas d'ouverture traversante, elle forme également un blindage électromagnétique efficace au-dessus du substrat, et une bonne protection à l'égard des décharges électrostatiques. Cette variante est particulièrement avantageuse avec un matériau pyroélectrique ne nécessitant pas d'être polarisé avant utilisation, par exemple du nitrure d'aluminium, ou un mélange de nitrures comprenant du nitrure d'aluminium. Si le matériau pyroélectrique nécessite d'être polarisé, le sens de polarisation doit être choisi de manière à protéger les transistors dans les circuits de contrôle CMOS. Cette variante est particulièrement avantageuse lorsque le matériau pyroélectrique et les LED GaN s'étendent jusqu'à même hauteur au-dessus du substrat.

De préférence, la surface de contact du capteur d'empreinte est formée sur une face supérieure de la couche conductrice 680, ou sur une face supérieure d'une couche de protection 660 recouvrant directement la couche conductrice (comme illustré en figure 6).

Un capteur d'empreinte basé sur l'utilisation d'un matériau pyroélectrique peut être utilisé selon différents modes de détection. Selon un mode de détection dit passif, on exploite une différence de température initiale entre les éléments de conversion pyroélectrique et l'empreinte.

Au niveau d'une crête, l'empreinte est en contact physique direct avec la surface de contact du capteur, réalisant ainsi un transfert thermique par conduction entre l'empreinte et un élément de conversion pyroélectrique. Le transfert de chaleur est efficace, ce qui se traduit par une forte variation de la température de l'élément de conversion pyroélectrique, dans les instants qui suivent le positionnement de l'empreinte sur la surface de contact.

Au niveau d'une vallée, l'empreinte n'est pas est en contact physique direct avec la surface de contact du capteur. Le transfert thermique entre l'empreinte et un élément de conversion pyroélectrique se fait par convection. Le transfert de chaleur est moindre, ce qui se traduit par une faible variation de la température de l'élément de conversion pyroélectrique, dans les instants qui suivent le positionnement de l'empreinte sur la surface de contact.

Un inconvénient de ce type de détection est que rapidement les températures ne varient plus, de sorte qu'il n'est plus possible d'imager une empreinte. Une solution consiste à déplacer l'empreinte relativement à la surface de contact du capteur, pour retarder ou éviter l'équilibre thermique. La matrice d'éléments de conversion pyroélectrique forme alors une matrice rectangulaire. Il reste que si l'empreinte et les éléments de conversion pyroélectrique présentent la même température initiale, il n'y aura aucune variation de température, et donc aucune charge pyroélectrique générée à mesurer.

Un autre mode de détection, dit actif, consiste à chauffer les éléments de conversion pyroélectrique. Ainsi, on augmente et on entretient un déséquilibre thermique entre les éléments de conversion pyroélectrique et l'empreinte.

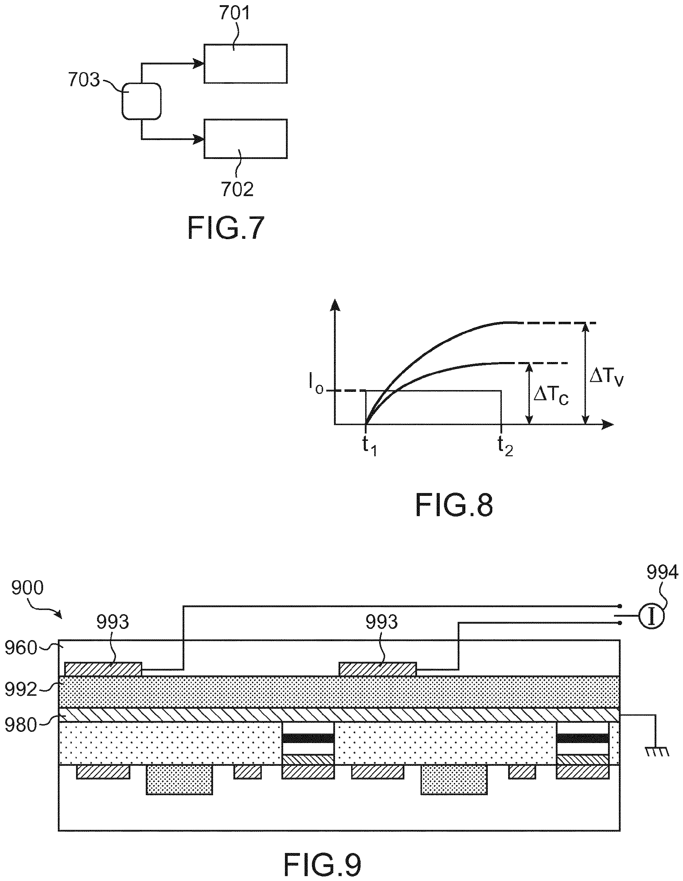

Les figures 7 et 8 illustrent de manière schématique le principe d'une détection thermique de type actif.

La figure 7 illustre très schématiquement le dispositif mis en œuvre pour chaque élément de conversion pyroélectrique, comportant :
- un dispositif 701 de mesure de charges électriques (ou, dit autrement, des moyens 701 de mesure de charges électriques), connectés à l'élément de conversion pyroélectrique, ici par l'intermédiaire de son électrode inférieure ;
- un élément de chauffage 702, agencé pour chauffer le matériel pyroélectrique de l'élément de conversion pyroélectrique ; et
- un dispositif de synchronisation 703 (ou, dit autrement, des moyens de synchronisation 703), connecté à l'élément de chauffage 702 et au dispositif de mesure 701, configuré pour piloter une mesure de charges à des instants prédéterminés relativement à l'activation du chauffage.

La figure 8 illustre une impulsion de courant fournie à l'élément de chauffage 702, définie par un courant constant I₀ entre les instants t₁ et t₂, et nul ailleurs. Cette impulsion de courant active le chauffage de l'élément de conversion pyroélectrique par l'élément de chauffage 702, entre les instants t₁ et t₂.

Lorsque l'élément de conversion pyroélectrique est recouvert par une vallée de l'empreinte, la chaleur est transmise à l'empreinte par convection par l'air. L'efficacité de ce transfert de chaleur est moindre, de sorte que la température de l'élément de conversion pyroélectrique augmente fortement entre les instants t₁ et t₂ (variation de température ΔTᵥ).

Lorsque l'élément de conversion pyroélectrique est recouvert par une crête de l'empreinte, la chaleur est transmise au doigt par conduction. L'efficacité de ce transfert de chaleur est grande, de sorte que la température de l'élément de conversion pyroélectrique augmente faiblement entre les instants t₁ et t₂ (variation de température ΔT_{c}<ΔTᵥ).

Ces variations de température correspondent à des charges générées, mesurées par le dispositif de mesure 701. En pratique, on remettra à zéro le dispositif de mesure 701 un court instant après t₁ pour éviter les parasites provoqués par le démarrage de l'injection de courant I₀ et on mesurera juste avant t₂.

Chaque élément de chauffage est connecté à une source de courant, respectivement de tension, configurée pour fournir un courant de chauffage, adaptée à chauffer ledit élément de chauffage par effet Joule. Chaque élément de chauffage peut être formé par une résistance de chauffage. Le capteur d'empreinte comprend par exemple une résistance de chauffage distincte, au-dessus (ou en dessous) de chaque élément de conversion pyroélectrique.

Selon une variante avantageuse, le capteur d'empreinte comprend des résistances de chauffage de forme allongée, s'étendant chacune au-dessus (ou en dessous) d'une ligne d'éléments de conversion pyroélectriques. Cette configuration est bien adaptée à une lecture ligne par ligne des éléments de conversion pyroélectrique.

La figure 9 illustre un troisième mode de réalisation, dérivé du mode de réalisation de la figure 6, dans lequel l'unique couche conductrice 980 est recouverte par un isolant électrique transparent 992 (par exemple du SiO₂, ou du Si₃N₄), lui-même surmonté par une pluralité de résistances électriques 993.

Les résistances électriques 993 sont reliées chacune à un circuit de connexion, pour la connexion à une source de courant 994 fournissant un courant de chauffage. Une couche de protection 960 recouvre les résistances 993 et l'isolant électrique 992. De préférence, les résistances électriques 993 s'étendent au-dessus du substrat sans recouvrir les photodiodes.

Selon un mode de réalisation non représenté, les éléments de chauffage sont formés par les électrodes supérieures des éléments de conversion pyroélectrique, ces dernières pouvant être connectées alternativement à un potentiel nul ou à une source de courant.

Selon un autre mode de réalisation, non représenté, l'au moins un élément de chauffage est formé par l'au moins une LED au nitrure de gallium du dispositif d'émission lumineuse. De préférence, chaque LED GaN formant le dispositif d'émission lumineuse est alors connectée à une source d'énergie lui fournissant une puissance électrique supérieure à 0,5 mW. La partie de la puissance injectée non convertie en lumière se retrouve sous forme de pertes de chaleur. Par exemple avec un rendement de 20%, 80% de la puissance est convertie en chaleur, que l'on met à profit pour chauffer les éléments pyroélectriques. L'insertion d'une résistance spécifique pour chauffer devient alors inutile.

Selon ce mode de réalisation, le dispositif de synchronisation tel que décrit en référence à la figure 7 est connecté aux LED GaN, pour piloter la mesure de charges pyroélectriques, à des instants prédéterminés relativement à l'allumage d'une ou plusieurs LED GaN du dispositif d'émission lumineuse.

On a décrit ci-avant un capteur d'empreinte dans lequel un étage recevant le dispositif d'émission lumineuse s'étend au-dessus d'un substrat recevant le photo-détecteur matriciel. En variante, un même étage peut recevoir à la fois le dispositif d'émission lumineuse et le photo-détecteur matriciel, au-dessus du substrat. Le photo-détecteur matriciel est alors constitué de photodiodes réalisées par report ou par des dépôts spécifiques sur le substrat.

Par exemple, chaque photodiode formant le photo-détecteur matriciel est une diode dite PiN (pour l'anglais « Positive Intrinsic Negative diode»), constituée d'une zone non-dopée, dite intrinsèque I, intercalée entre deux zones dopées P et N. L'un des avantages de ce type de photodiode est sa forte sensibilité. Les diodes PiN sont reportées ou déposées sur le substrat avant ou après réalisation de l'au moins une LED GaN et avant dépôt du matériau pyroélectrique.

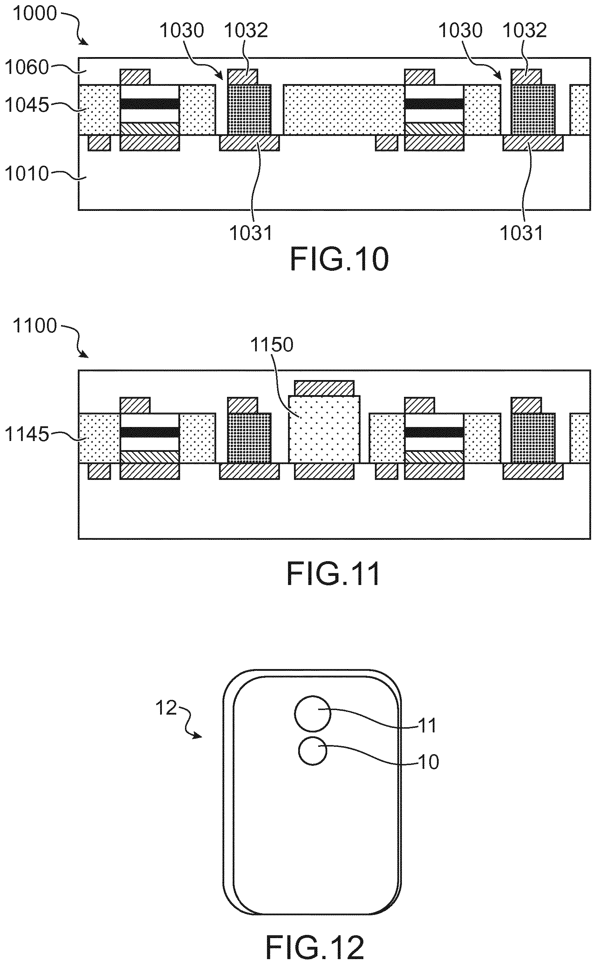

Les figures 10 et 11 illustrent deux variantes dans lesquelles le photo-détecteur matriciel est constitué d'une matrice de diodes PiN. Le capteur d'empreinte 1000 ne sera décrit que pour ses différences relativement au capteur d'empreinte de la figure 1.

Le photo-détecteur matriciel est constitué ici de diodes PiN 1030, s'étendant chacune au-dessus d'une piste métallique dédiée 1031 du substrat 1010, et recouvertes chacune d'une métallisation 1032 formant électrode supérieure. Chaque diode PiN 1030 s'étend dans une ouverture traversante gravée dans un premier isolant électrique 1045.

Un deuxième isolant électrique 1060, transparent, s'étend d'un seul tenant et sans ouverture au-dessus du substrat 1010, en recouvrant les diodes PiN 1030 et les LED GaN, et en comblant les espaces restants entre une diode PiN 1030 et le premier isolant électrique 1045. Le deuxième isolant électrique 1060 forme également une couche de protection à l'égard de contacts répétés avec des tissus humains.

Le capteur d'empreinte 1100 de la figure 11 correspond au capteur d'empreinte de la figure 10, et comprend en outre une matrice d'éléments de conversion pyroélectrique. Chaque élément de conversion pyroélectrique s'étend dans une ouverture traversante gravée dans le premier isolant électrique 1145, une même ouverture traversante pouvant recevoir à la fois un élément de conversion pyroélectrique et une diode PiN. Le matériau pyroélectrique 1150 n'est pas nécessairement transparent, puisque placé à côté et non au-dessus des photodiodes.

De nombreuses autres variantes de l'invention peuvent être mises en œuvre, dans lesquelles le photo-détecteur matriciel est constitué de diodes PiN rapportées sur le substrat. En particulier, les exemples décrits en référence aux figures 1 à 9 peuvent être adaptés à un photo-détecteur matriciel constitué de diodes PiN.

L'invention trouve une application particulièrement avantageuse dans un téléphone intelligent 12, équipé d'un appareil photo 11 et d'un capteur d'empreinte 10. Le dispositif d'émission lumineuse du capteur d'empreinte 10 étant constitué d'au moins une LED GaN, il peut fournir un éclairage suffisamment puissant pour former en outre un flash pour l'appareil photo 11. Le substrat recevant le capteur d'empreinte peut recevoir en outre une ou plusieurs LED GaN spécifique(s), destinée(s) plus spécifiquement à former un flash pour l'appareil photo.

## Revendications

1. Capteur d'empreinte papillaire (100; 400; 500; 600; 900; 1000; 1100; 10), comprenant :
- un dispositif d'émission lumineuse, configuré pour émettre un rayonnement lumineux en direction de l'empreinte papillaire ; et
- un photo-détecteur matriciel, configuré pour être sensible à au moins une partie d'un spectre d'émission du dispositif d'émission lumineuse ;
le dispositif d'émission lumineuse et le photo-détecteur matriciel étant répartis ensemble dans et/ou au-dessus d'un même substrat semiconducteur (110 ; 410 ; 1010),
**caractérisé en ce que** le dispositif d'émission lumineuse est constitué de plusieurs diodes électroluminescentes au nitrure de gallium (140 ; 440 ; 540 ; 640 ; 1401, 1402, 1403) dite LED au nitrure de gallium, s'étendant chacune sans recouvrement entre des photodiodes du photo-détecteur matriciel, ou d'une unique LED au nitrure de gallium en forme d'une grille ayant une série d'ouvertures traversantes, avec des photodiodes du photo-détecteur matriciel s'étendant chacune dans lesdites ouvertures traversantes.

2. Capteur d'empreinte papillaire (100 ; 400 ; 500 ; 600 ; 900 ; 10) selon la revendication 1, **caractérisé en ce que** le photo-détecteur matriciel s'étend selon une surface dite surface de capture du capteur d'empreinte papillaire, dans un premier étage du capteur d'empreinte papillaire, **en ce que** le dispositif d'émission lumineuse s'étend dans un deuxième étage du capteur d'empreinte papillaire, et **en ce que** le deuxième étage s'étend au-dessus du premier étage, le deuxième étage étant superposé au-dessus du premier étage selon un axe (Oz) orthogonal au plan de la surface du capture.

3. Capteur d'empreinte papillaire (100 ; 400 ; 500 ; 600 ; 900 ; 10) selon la revendication 2, **caractérisé en ce que** le substrat semiconducteur (110 ; 410) reçoit le photo-détecteur matriciel et forme ainsi ledit premier étage du capteur d'empreinte papillaire.

4. Capteur d'empreinte papillaire (100 ; 400 ; 500 ; 600 ; 900 ; 1000 ; 1100 ; 10) selon l'une quelconque des revendications 1 à 3, **caractérisé en ce que** le dispositif d'émission lumineuse et le photo-détecteur matriciel sont entrelacés ensemble dans et/ou au-dessus du substrat semiconducteur (110 ; 410 ; 1010), et **en ce que** le substrat reçoit des circuits de contrôle comportant une pluralité de pistes métalliques de connexion (120), chaque LED au nitrure de gallium s'étendant au-dessus d'une piste métallique des circuits de contrôle.

5. Capteur d'empreinte papillaire (100 ; 400 ; 500 ; 600 ; 900 ; 10) selon l'une quelconque des revendications 1 à 4, **caractérisé en ce que** l'au moins une LED au nitrure de gallium (140 ; 440 ; 540 ; 640 ; 1401, 1402, 1403) du dispositif d'émission lumineuse est décalée longitudinalement et transversalement relativement à des photo-détecteurs (130 ; 430 ; 1030) du photo-détecteur matriciel.

6. Capteur d'empreinte papillaire (100 ; 400 ; 500 ; 600 ; 900 ; 1000 ; 1100 ; 10) selon l'une quelconque des revendications 1 à 5, **caractérisé en ce qu'**une distance entre une surface supérieure d'une couche la plus externe du capteur d'empreinte papillaire, du côté opposé au substrat, et le photo-détecteur matriciel, est inférieure ou égale à un pas de répartition des photo-détecteurs formant le photo-détecteur matriciel.

7. Capteur d'empreinte papillaire (100 ; 400 ; 500 ; 600 ; 900 ; 1000 ; 1100 ; 10) selon l'une quelconque des revendications 1 à 6, **caractérisé en ce que** le dispositif d'émission lumineuse est constitué de plusieurs LED au nitrure de gallium (140 ; 440 ; 540 ; 640 ; 1401, 1401, 1403), réparties selon une matrice de répartition à N lignes et M colonnes, avec N et M des entiers supérieurs à 3 pouvant être égaux, ou de plusieurs LED au nitrure de gallium (140 ; 440 ; 540 ; 640), chacune en forme de bande, réparties selon une ou deux colonnes de bandes parallèles entre elles.

8. Capteur d'empreinte papillaire (100 ; 400 ; 500 ; 600 ; 900 ; 1000 ; 1100 ; 10) selon l'une quelconque des revendications 1 à 7, **caractérisé en ce que** le dispositif d'émission lumineuse est polychromatique, au moins une des LED au nitrure de gallium (140 ; 440 ; 540 ; 640 ; 1401, 1401, 1403) comprenant un empilement actif de LED recouvert par un ou plusieurs empilement(s) de conversion photoluminescent(s).

9. Capteur d'empreinte papillaire (400 ; 500 ; 600 ; 900 ; 1100 ; 10) selon l'une quelconque des revendications 1 à 8, **caractérisé en ce qu'**il comprend en outre un matériau pyroélectrique (450 ; 550 ; 1150) s'étendant entre les LED au nitrure de gallium (440 ; 540 ; 640 ; 1401, 1401, 1403), ou dans les ouvertures traversantes de l'unique LED au nitrure de gallium, le matériau pyroélectrique s'étendant en outre entre une ou plusieurs électrode(s) inférieure(s) (451), du côté du substrat, et une ou plusieurs électrode(s) supérieure(s) (452 ; 552 ; 680 ; 980), du côté opposé au substrat, de manière à former une matrice d'éléments de conversion pyroélectrique.

10. Capteur d'empreinte papillaire (400 ; 500 ; 600 ; 900 ; 10) selon la revendication 9, **caractérisé en ce que** le photo-détecteur matriciel est constitué de photodiodes formées dans le substrat semiconducteur, et **en ce que** le matériau pyroélectrique (450 ; 550) remplit entièrement les espaces entre les LED au nitrure de gallium (440 ; 540 ; 640 ; 1401, 1401, 1403), respectivement les ouvertures traversantes de l'unique LED au nitrure de gallium.

11. Capteur d'empreinte papillaire (600 ; 900) selon la revendication 9 ou 10, **caractérisé en ce que** chaque LED au nitrure de gallium (640) du dispositif d'émission lumineuse comprend une électrode supérieure de LED, du côté opposé au substrat, l'au moins une électrode supérieure de LED et l'au moins une électrode supérieure du matériau pyroélectrique étant formées ensemble d'un seul tenant par une même couche conductrice (680 ; 980), transparente, qui s'étend sans ouverture au-dessus du substrat.

12. Capteur d'empreinte papillaire (900) selon l'une quelconque des revendications 9 à 11, **caractérisé en ce que** les éléments de conversion pyroélectrique sont connectés chacun à des dispositifs de mesure (701) de charges pyroélectriques, et **en ce que** le capteur d'empreinte papillaire comprend en outre :
- au moins un élément de chauffage (702 ; 891 ; 993, 994), pour chauffer les éléments de conversion pyroélectrique ; et
- un dispositif de synchronisation (703), connecté au dispositif de mesure (701) et à l'élément de chauffage d'un même élément de conversion pyroélectrique, et agencés pour piloter une mesure des charges pyroélectriques générées par l'élément de conversion pyroélectrique, à des instants prédéterminés relativement à l'activation dudit élément de chauffage.

13. Capteur d'empreinte papillaire (900) selon la revendication 12, **caractérisé en ce que** l'au moins un élément de chauffage comprend une série de résistances électriques (993) s'étendant au-dessus d'une couche d'isolation électrique (992), recouvrant elle-même ladite couche conductrice (980).

14. Téléphone intelligent (12) équipé de moyens d'acquisition d'image (11) et d'un flash, **caractérisé en ce qu'**il comprend un capteur d'empreinte papillaire (10) selon l'une quelconque des revendications 1 à 13, et **en ce que** le flash est constitué par une pluralité de LED au nitrure de gallium formées sur le substrat du capteur d'empreinte papillaire.

15. Procédé de fabrication d'un capteur d'empreinte papillaire (100 ; 400 ; 500 ; 600 ; 900 ; 1000 ; 1100 ; 10) selon l'une quelconque des revendications 1 à 13, **caractérisé en ce qu'**il comporte les étapes suivantes :
a) rapporter, sur une face du substrat semiconducteur (110 ; 410 ; 1010), un empilement actif de LED comportant au moins des première et deuxième couches semi-conductrices dopées de types de conductivité opposés ;
b) former dans l'empilement actif des tranchées pour délimiter les plusieurs LED au nitrure de gallium (140 ; 440 ; 540 ; 640 ; 1401, 1401, 1403) ou pour percer les ouvertures traversantes dans l'unique LED au nitrure de gallium ; et
c) réaliser le photo-détecteur matriciel dans ou au-dessus du substrat, l'étape c) étant mise en œuvre avant ou après les étapes a) et b).

## Patentansprüche

1. Papillarabdrucksensor (100; 400; 500; 600; 900; 1000; 1100; 10), umfassend:
- eine Lichtemissionsvorrichtung, die dazu konfiguriert ist, eine Lichtstrahlung in Richtung des Papillarabdrucks zu emittieren; und
- einen Matrixphotodetektor, der dazu konfiguriert ist, auf wenigstens einen Teil eines Emissionsspektrums der Lichtemissionsvorrichtung empfindlich zu sein;
wobei die Lichtemissionsvorrichtung und der Matrixphotodetektor gemeinsam in und/oder über ein und demselben Halbleitersubstrat (110; 410; 1010) verteilt sind, **dadurch gekennzeichnet, dass** die Lichtemissionsvorrichtung aus mehreren Elektrolumineszenzdioden mit Galliumnitrid (140; 440; 540; 640; 1401, 1402, 1403) gebildet ist, genannt Galliumnitrid-LED, die sich jeweils ohne Abdeckung zwischen Photodioden des Matrixphotodetektors erstrecken, oder aus einer einzigen Galliumnitrid-LED in Form eines Gitters mit einer Reihe von durchgehenden Öffnungen, wobei sich Photodioden des Matrixphotodetektors jeweils in den durchgehenden Öffnungen erstrecken.

2. Papillarabdrucksensor (100; 400; 500; 600; 900; 10) nach Anspruch 1, **dadurch gekennzeichnet, dass** sich der Matrixphotodetektor entlang einer Oberfläche, genannt Messoberfläche des Papillarabdrucksensors, in einer ersten Stufe des Papillarabdrucksensors erstreckt, dass sich die Lichtemissionsvorrichtung in einer zweiten Stufe des Papillarabdrucksensors erstreckt, und dass sich die zweite Stufe über der ersten Stufe erstreckt, wobei die zweite Stufe über der ersten Stufe entlang einer Achse (Oz) orthogonal zur Ebene der Messoberfläche überlagert ist.

3. Papillarabdrucksensor (100; 400; 500; 600; 900; 10) nach Anspruch 2, **dadurch gekennzeichnet, dass** das Halbleitersubstrat (110; 410) den Matrixphotodetektor aufnimmt und somit die erste Stufe des Papillarabdrucksensors bildet.

4. Papillarabdrucksensor (100; 400; 500; 600; 900; 1000; 1100; 10) nach einem der Ansprüche 1 bis 3, **dadurch gekennzeichnet, dass** die Lichtemissionsvorrichtung und der Matrixphotodetektor gemeinsam in und/oder über dem Halbleitersubstrat (110; 410; 1010) verschachtelt sind, und dass das Substrat Steuerschaltkreise aufnimmt, die eine Mehrzahl von metallischen Verbindungsbahnen (120) umfassen, wobei sich jede Galliumnitrid-LED über einer metallischen Bahn der Steuerschaltkreise erstreckt.

5. Papillarabdrucksensor (100; 400; 500; 600; 900; 10) nach einem der Ansprüche 1 bis 4, **dadurch gekennzeichnet, dass** wenigstens eine Galliumnitrid-LED (140; 440; 540; 640; 1401, 1402, 1403) der Lichtemissionsvorrichtung longitudinal und transversal relativ zu Photodetektoren (130; 430; 1030) des Matrixphotodetektors versetzt ist.

6. Papillarabdrucksensor (100; 400; 500; 600; 900; 1000; 1100; 10) nach einem der Ansprüche 1 bis 5, **dadurch gekennzeichnet, dass** ein Abstand zwischen einer oberen Oberfläche einer am weitesten außen liegenden Schicht des Papillarabdrucksensors auf der Seite entgegengesetzt zum Substrat und dem Matrixphotodetektor kleiner oder gleich einem Verteilungsabstand der Photodetektoren ist, die den Matrixphotodetektor bilden.

7. Papillarabdrucksensor (100; 400; 500; 600; 900; 1000; 1100; 10) nach einem der Ansprüche 1 bis 6, **dadurch gekennzeichnet, dass** die Lichtemissionsvorrichtung aus mehreren Galliumnitrid-LED (140; 440; 540; 640; 1401, 1401, 1403) gebildet ist, die gemäß einer Verteilungsmatrix mit N Zeilen und M Spalten verteilt sind, wobei N und M ganze Zahlen größer als 3 sind, die gleich sein können, oder aus mehreren Galliumnitrid-LED (140; 440; 540; 640), jeweils in Bandform, die entlang einer oder zwei Spalten zueinander parallelen Bändern verteilt sind.

8. Papillarabdrucksensor (100; 400; 500; 600; 900; 1000; 1100; 10) nach einem der Ansprüche 1 bis 7, **dadurch gekennzeichnet, dass** die Lichtemissionsvorrichtung polychromatisch ist, wobei wenigstens eine der Galliumnitrid-LED (140; 440; 540; 640; 1401, 1401, 1403) einen aktiven LED-Stapel umfasst, der durch einen oder mehrere photolumineszente(n) Umwandlungsstapel bedeckt ist.

9. Papillarabdrucksensor (400; 500; 600; 900; 1100; 10) nach einem der Ansprüche 1 bis 8, **dadurch gekennzeichnet, dass** er ferner ein pyroelektrisches Material (450; 550; 1150) umfasst, das sich zwischen den Galliumnitrid-LED (440; 540; 640; 1401, 1401, 1403) erstreckt, oder in den durchgehenden Öffnungen der einzigen Galliumnitrid-LED, wobei sich das pyroelektrische Material ferner zwischen einer oder mehreren unteren Elektrode(n) (451) auf der Seite des Substrats und einer oder mehreren oberen Elektrode(n) (452; 552; 680; 980) auf der zum Substrat entgegengesetzten Seite derart erstreckt, dass eine Matrix von pyroelektrischen Umwandlungselementen gebildet wird.

10. Papillarabdrucksensor (400; 500; 600; 900; 10) nach Anspruch 9, **dadurch gekennzeichnet, dass** der Matrixphotodetektor aus Photodioden gebildet ist, die in dem Halbleitersubstrat gebildet sind, und dass das pyroelektrische Material (450; 550) die Zwischenräume zwischen den Galliumnitrid-LED (440; 540; 640; 1401, 1401, 1403) beziehungsweise den durchgehenden Öffnungen der einzigen Galliumnitrid-LED vollständig füllt.

11. Papillarabdrucksensor (600; 900) nach Anspruch 9 oder 10, **dadurch gekennzeichnet, dass** jede Galliumnitrid-LED (640) der Lichtemissionsvorrichtung eine obere LED-Elektrode auf der zum Substrat entgegengesetzten Seite umfasst, wobei die wenigstens eine obere LED-Elektrode und die wenigstens eine obere Elektrode des pyroelektrischen Materials gemeinsam einstückig durch ein und dieselbe leitende transparente Schicht (680; 980) gebildet sind, die sich ohne Öffnung über dem Substrat erstreckt.

12. Papillarabdrucksensor (900) nach einem der Ansprüche 9 bis 11, **dadurch gekennzeichnet, dass** die pyroelektrischen Umwandlungselemente jeweils mit Vorrichtungen (701) zur Messung von pyroelektrischen Ladungen verbunden sind, und dass der Papillarabdrucksensor ferner umfasst:
- wenigstens ein Heizelement (702; 891; 993; 994) zum Heizen der pyroelektrischen Umwandlungselemente; und
- eine Synchronisationsvorrichtung (703), die mit der Messvorrichtung (701) und mit dem Heizelement ein und desselben pyroelektrischen Umwandlungselements verbunden ist, und dazu ausgelegt ist, eine Messung der pyroelektrischen Ladungen, die durch das pyroelektrische Umwandlungselement erzeugt werden, zu vorbestimmten Zeitpunkten relativ zur Aktivierung des Heizelements zu steuern.

13. Papillarabdrucksensor (900) nach Anspruch 12, **dadurch gekennzeichnet, dass** das wenigstens eine Heizelement eine Reihe von elektrischen Widerständen (993) umfasst, die sich über einer elektrischen Isolationsschicht (992) erstrecken, die selbst wiederum die leitende Schicht (980) bedeckt.

14. Intelligentes Telefon (12), das mit Bilderfassungsmitteln (11) und mit einem Blitzlicht ausgestattet ist, **dadurch gekennzeichnet, dass** es einen Papillarabdrucksensor (10) nach einem der Ansprüche 1 bis 13 umfasst, und dass das Blitzlicht durch eine Mehrzahl von Galliumnitrid-LED gebildet ist, die auf dem Substrat des Papillarabdrucksensors gebildet sind.

15. Verfahren zur Herstellung eines Papillarabducksensors (100; 400; 500; 600; 900; 1000; 1100; 10) nach einem der Ansprüche 1 bis 13, **dadurch gekennzeichnet, dass** es die folgenden Schritte umfasst:
a) Aufbringen, auf einer Fläche des Halbleitersubstrats (110; 410; 1010), eines aktiven LED-Stapels, umfassend wenigstens erste und zweite Halbleiterschichten, die mit entgegengesetzten Leitfähigkeitstypen dotiert sind;
b) Bilden von Gräben in dem aktiven Stapel, um die mehreren Galliumnitrid-LED (140; 440; 540; 640; 1401, 1401, 1403) zu begrenzen, oder um die durchgehenden Öffnungen in die einzige Galliumnitrid-LED zu bohren; und
c) Realisieren des Matrixphotodetektors in oder über dem Substrat, wobei der Schritt c) vor oder nach den Schritten a) und b) durchgeführt wird.

## Claims

1. Papillary print sensor (100; 400; 500; 600; 900 ;1000 ;1100; 10), comprising:
- a light emitting device configured to emit light radiation towards the papillary print; and
- a matrix photodetector configured to be sensitive to at least part of an emission spectrum of the light emitting device;
the light emitting device and the matrix photodetector being distributed together in and/or above the same semiconducting substrate (110; 410; 1010),
**characterized in that** the light emitting device is composed of several gallium nitride light emitting diodes (140; 440; 540; 640 ;1401; 1402; 1403), called gallium nitride LEDs, each one extending without overlap between photodiodes of the matrix photodetector, or a single grid-shaped gallium nitride LED with a series of through openings, with photodiodes of the matrix photodetector each one extending in said through openings.

2. Papillary print sensor (100; 400; 500; 600; 900; 10) according to claim 1, **characterized in that** the matrix photodetector extends along a surface called the capture surface of the papillary print sensor, in a first stage of the papillary print sensor, **in that** the light emitting device extends in a second stage of the papillary print sensor, and **in that** the second stage extends above the first stage, the second stage being superposed above the first stage along an axis (Oz) orthogonal to the plane of the capture surface.

3. Papillary print sensor (100; 400; 500; 600; 900; 10) according to claim 2, **characterized in that** the semiconducting substrate (110; 410) contains the matrix photodetector and thus forms said first stage of the papillary print sensor.

4. Papillary print sensor (100; 400; 500; 600; 900 ;1000; 1100; 10) according to any one of claims 1 to 3, **characterized in that** the light emitting device and the matrix photodetector are interlaced together in and/or above the semiconducting substrate (110; 410; 1010), and **in that** the substrate holds control circuits comprising a plurality of metallic connection tracks (120), each gallium nitride LED extending above a metallic track of the control circuits.

5. Papillary print sensor (100; 400; 500; 600; 900; 10) according to any one of claims 1 to 4, **characterized in that** the at least one gallium nitride LED (140; 440; 540; 640; 1401; 1402; 1403) of the light emitting device is offset from the photodetectors (130; 430; 1030) of the matrix photodetector in the longitudinal and transverse directions.

6. Papillary print sensor (100; 400; 500; 600; 900; 1000; 1100; 10) according to any one of claims 1 to 5, **characterized in that** a distance between an upper surface of an outermost layer of the papillary print sensor on the side opposite the substrate, and the matrix photodetector, is less than or equal to a distribution pitch of the photodetectors forming the matrix photodetector.

7. Papillary print sensor (100; 400; 500; 600; 900; 1000; 1100; 10) according to any one of claims 1 to 6, **characterized in that** the light emitting device is composed of several gallium nitride LEDs (140; 440; 540; 640; 1401, 1401, 1403), distributed in a distribution array with N rows and M columns, in which N and M are integers greater than 3 and possibly equal to each other, or of several gallium nitride LEDs (140; 440; 540; 640), each in the form of a strip, distributed in one or two columns of strips parallel to each other.

8. Papillary print sensor (100; 400; 500; 600; 900; 1000; 1100; 10) according to any one of claims 1 to 7, **characterized in that** the light emitting device is polychromatic, at least one of the gallium nitride LEDs (140; 440; 540; 640; 1401, 1401, 1403) comprising an active LED stack covered by one or several photoluminescent conversion stack(s).

9. Papillary print sensor (400; 500; 600; 900; 1100; 10) according to any one of claims 1 to 8, **characterized in that** it also comprises a pyroelectric material (450; 550; 1150) extending between the gallium nitride LEDs (440; 540; 640; 1401, 1401, 1403), or in the through openings in the single gallium nitride LED, the pyroelectric material also extending between one or several lower electrode(s) (451) on the side of the substrate, and one or several upper electrode(s) (452; 552; 680; 980) on the side opposite the substrate, so as to form an array of pyroelectric conversion elements.

10. Papillary print sensor (400; 500; 600; 900; 10) according to claim 9, **characterized in that** the matrix photodetector is composed of photodiodes formed in the semiconducting substrate, and **in that** the pyroelectric material (450; 550) completely fills the spaces between the gallium nitride LEDs (440; 540; 640; 1401, 1401, 1403), respectively the through openings in the single gallium nitride LED.

11. Papillary print sensor (600; 900) according to claim 9 or 10, wherein each gallium nitride LED (640) of the light emitting device comprises an upper LED electrode on the side opposite the substrate, the at least one upper LED electrode and the at least one upper electrode of the pyroelectric material together being formed in a single piece by a same transparent conducting layer (680; 980) that extends without any openings above the substrate

12. Papillary print sensor (900) according to any of claims 9 to 11, **characterized in that** each of the pyroelectric conversion elements is connected to a device for the measurement (701) of pyroelectric charges, and **in that** the papillary print sensor also comprises:
- at least one heating element (702; 891; 993; 994), to heat the pyroelectric conversion elements; and
- a synchronisation device (703), connected to the measurement device (701) and to the heating element of a same pyroelectric conversion element, and configured to drive a measurement of pyroelectric charges generated by the pyroelectric conversion element, at predetermined times after said heating element is activated.

13. Papillary print sensor (900) according to claim 12, **characterized in that** the at least one heating element comprises a series of electrical resistances (993) extending above an electrical insulation layer (992), itself covering said conducting layer (980).

14. Smart phone (12) equipped with image acquisition means (11) and a flash, **characterized in that** it comprises a papillary print sensor (10) according to any one of claims 1 to 13, and **in that** the flash is composed of a plurality of gallium nitride LEDs formed on the substrate of the papillary print sensor.

15. Method of fabrication a papillary print sensor (100; 400; 500; 600; 900; 1000; 1100; 10) according to any one of claims 1 to 13, **characterized in that** it includes the following steps:
a) add an active LED stack onto a face of the semiconducting substrate (110; 410; 1010), comprising at least first and second doped semiconducting layers with opposite types of conductivity;
b) form trenches in the active stack to delimit the several gallium nitride LEDs (140; 440; 540; 640; 1401, 1401, 1403) or to pierce openings passing through the single gallium nitride LED; and
c) make the matrix photodetector in or above the substrate, step c) being implemented before or after steps a) and b).
